Europäisches Patentamt

European Patent Office

Office européen des brevets

(11) Veröffentlichungsnummer: **0 217 095**
**A2**

(12) **EUROPÄISCHE PATENTANMELDUNG**

(21) Anmeldenummer: 86111441.1

(22) Anmeldetag: 19.08.86

(51) Int. Cl.4: **H01L 31/02** , **H01L 31/18**

(30) Priorität: 03.09.85 DE 3531473

(43) Veröffentlichungstag der Anmeldung:
08.04.87 Patentblatt 87/15

(84) Benannte Vertragsstaaten:
DE FR GB

(71) Anmelder: **Siemens Aktiengesellschaft Berlin und München**
**Wittelsbacherplatz 2**
**D-8000 München 2(DE)**

(72) Erfinder: **Primig, Robert**
**Milchstrasse 12**
**D-8000 München 80(DE)**
Erfinder: **Müller, Werner**
**Zeppelinstrasse 5**
**D-8025 Unterhaching(DE)**
Erfinder: **Doneyer, Helmut**
**Plantanenstrasse 88**
**D-8028 Taufkirchen(DE)**

(54) **Verfahren zum Herstellen niederohmiger, transparenter Indium-Zinnoxid-Schichten, insbesondere für Bildsensorelemente.**

(57) Die durch Aufdampfen oder Aufstäuben auf amorphe, wasserstoffhaltige Siliziumschichten aufgebrachten Indium-Zinnoxid-Schichten werden einem zweistufigen Temperprozeß bei maximal 200°C unterworfen, wobei in der ersten Stufe zur Erreichung der Transparenz in Sauerstoffatmosphäre und in der zweiten Stufe für die Leitfähigkeit in einer plasmaaktivierten Formiergasatmosphäre getempert wird. Dadurch wird erreicht, daß bei gleichbleibender Transparenz (95 %) die Leitfähigkeit um den Faktor 7 verbessert wird. Das Verfahren wird verwendet bei der Herstellung von transparenten Elektroden für Bildsensorelemente in der Bürokommunikation.

FIG 2

EP 0 217 095 A2

## Verfahren zum Herstellen niederohmiger, transparenter Indium-Zinnoxid-Schichten, insbesondere für Bildsensorelemente.

Die Erfindung betrifft ein Verfahren zum Herstellen niederohmiger, transparenter Indium-Zinnoxid-Schichten, wie sie insbesondere als transparente Elektroden auf aus amorphem, wasserstoffhaltigem Silizium bestehenden Photoleiterschichten für Bildsensorelemente verwendet werden, durch Aufdampfen oder Aufstäuben der Ausgangsmaterialien in Form von Legierungen oder Oxiden auf die Photoleiterschicht und nachträgliches Tempern in Sauerstoffatmosphäre.

Bei der Herstellung von Photosensoren werden im wesentlichen drei Materialien zum Sensorbauelement zusammengefügt: eine Photoleiterschicht befindet sich sandwichartig zwischen zwei Elektroden, von denen mindestens eine Elektrode, nämlich die Deckelektrode, transparent ist und durch ihre Lichtdurchlässigkeit eine Aktivierung des Photoleiters ermöglicht.

Für Bildsensorelemente werden heute als Photoleiterschichten durch plasmaaktiverten Gasphasenniederschlag hergestellte amorphe wasserstoffhaltige Silizium (a-Si:H)-Schichten verwendet, als transparente Elektroden Indium-Zinnoxid - (ITO)-Schichten.

Die Anforderungen, die an diese ITO-Schichten gestellt werden, sind: eine hohe Leitfähigkeit bei hoher Transparenz (mindestens 95 %). Weitere Einzelheiten über diese Anforderungen und über den Aufbau dieser ITO-Schichten sind einem Bericht von K. L. Chopra et. al. "Transparent Conductors -A Status Review" aus der Zeitschrift Thin Solid Films, 102, (1983) Seiten 1 bis 46 zu entnehmen.

Für die Herstellung der ITO-Schichten auf Photoleitern aus a-Si:H gibt es mehrere Möglichkeiten. So sind zum Beispiel nach einem Aufsatz von Habermeier aus Thin Solid Films 80 (1981), auf den Seiten 157 bis 160 oder aus einem Aufsatz von P. Nath et. al. aus Thin Solid Films 69 (1980), Seiten 63 bis 68, reaktive Aufdampfverfahren für ITO-Schichten zu entnehmen, bei denen die Legierung aus widerstandsbeheizten Wolfram-oder Wolfram/Tantal-Booten bei 420°C bzw. 350°C Substrattemperatur aufgedampft wird. Die Transparenz dieser Schichten liegt zwischen 90 bis 96 %, der gemessene Widerstand bei 20 bis 25 Ohm/□.

Aus einem Aufsatz von K. Sreenivas et. al. aus dem J. Appl. Phys. 57 (2) 15.1.1985, Seiten 384 bis 392 ist bekannt, ITO-Schichten durch HF-Zerstäuben (rf sputtering) der Legierung in Argon/Sauerstoff-Atmosphäre herzustellen und anschließend eine Temperung in Ammoniak bei 350°C durchzuführen. Durch diese Maßnahmen werden Widerstandswerte von 300 Ohm/□ -das sind 5 $\times$ 10$^{-4}$ Ohm cm -(800 Å Schichtdicke) bei einer Transparenz von 95 % erhalten.

Der Erfindung liegt nun die Aufgabe zugrunde, ein Verfahren anzugeben, welches die Widerstandswerte bei gleichbleibender Transparenz noch verbessert. Dabei wurde von der Erkenntnis ausgegangen, daß es durch die bei der Herstellung und durch die zur Erzielung der erforderlichen Leitfähigkeit und Transparenz nach der Herstellung erfolgte Temperaturbelastung von über 300°C zu erheblichen Beeinträchtigungen der Materialeigenschaften des aus a-Si:H bestehenden Photoleiters kommt.

Die Erfindung löst die gestellte Aufgabe bei einem Verfahren der eingangs genannten Art dadurch, daß die Temperung in zwei Schritten bei Temperaturen von maximal 200°C durchgeführt wird, wobei

a) im ersten Schritt zur Erreichung der Transparenz in Sauerstoffatmosphäre und

b) im zweiten Schritt für die Leitfähigkeit der Schicht in einer plasmaaktivierten Formiergasatmosphäre getempert wird.

Auf diese Weise wird die Tempertemperatur an die Herstelltemperatur der a-Si:H-Schicht (220°C) angepaßt und eine Temperaturbelastung, die die Eigenschaften der Schicht verändern könnte, vermieden.

Weitere Ausgestaltungen der Erfindung ergeben sich aus den Unteransprüchen.

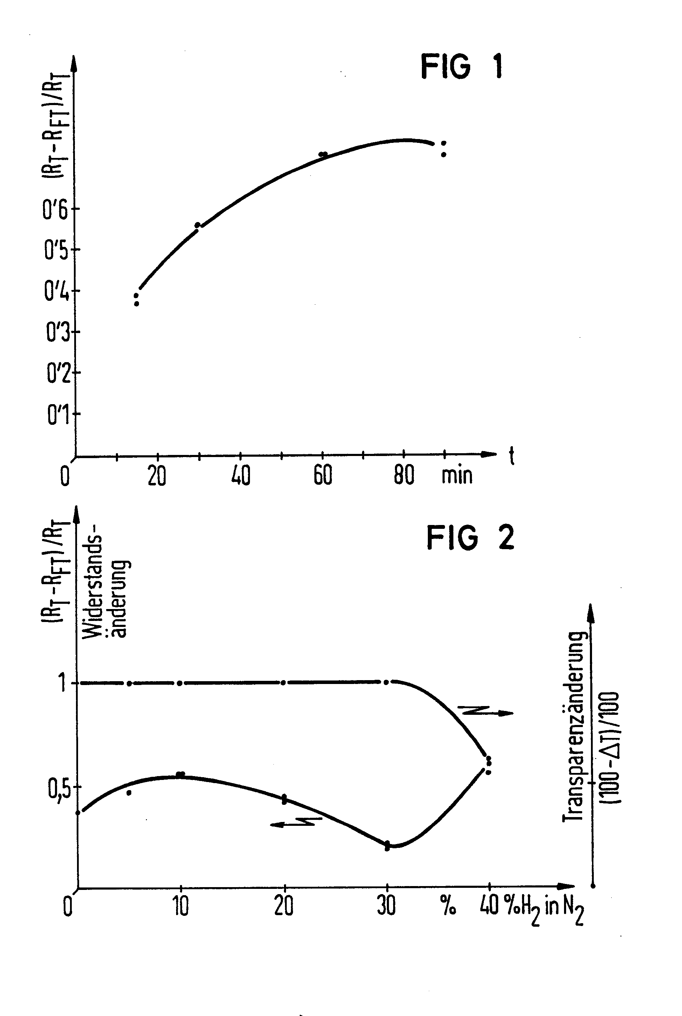

Die Erfindung wird nachfolgend anhand eines Ausführungsbeispieles und der Figuren 1 und 2, welche die erzielten Ergebnisse in bezug auf Transparenz und Leitfähigkeit der Schicht zeigen, noch näher erläutert.

Die Prozeßparameter für die Herstellung der erfindungsgemäßen ITO-Schicht sind folgende:

1. Aufdampfen des in einer Indium-Zinn (20 %)-Legierung vorliegenden Ausgangsmaterials mittels einer Elektronenstrahlkanone bei 6 kV und einem Sauerstoff-Partialdruck von 3,5 $\times$ 10$^{-4}$ mbar; Aufdampfrate: 0,1 nm/sec.

2. Transparenztemperung in Sauerstoff-Atmosphäre, 200°C, ca. 60 Minuten lang.

3. Leitfähigkeitstemperung im Stickstoff-10 % Wasser stoff-Plasma mit 40 Watt HF-Leistung bei einem Druck von 1,2 mbar und einer Gasströmung von 50 sccm (Standard ccm) bei 200°C, 30 Minuten lang.

Durch den zweistufigen Temperprozeß bei einer Temperatur, die nicht höher liegt als die Temperatur, bei der die a-Si:H-Photoleiterschicht hergestellt wurde, wird eine Verbesserung der Leitfähigkeit bei gleichbleibender Transparenz der ITO-Schicht um den Faktor 7 erreicht.

Die Figur 1 zeigt in einem Kurvendiagramm die Erniedrigung des Widerstandes $(R_T - R_{FT})/R_T$ nach der plasmaaktivierten Formiergastemperung in Abhängigkeit von der Zeit t (min). $R_T$ bedeutet Widerstandsmessung nach Sauerstoff-Temperung, $R_{FT}$ ist die Widerstandsmessung nach der plasmaaktivierten Stickstoff-Wasserstoff-Temperung.

In Figur 2 ist der Einfluß des Wasserstoffgehaltes im Formiergas (Stickstoff) auf die Widerstandsänderung $(R_T - R_{FT})/R_T$ (linke Ordinate) und der Transparenzänderung $(100 - \Delta T)/100$ (rechte Ordinate) dargestellt. Die Schicht wurde hergestellt nach den beim Ausführungsbeispiel angegebenen Parametern.

Wie aus dem Kurvendiagramm der Figur 2 zu entnehmen ist, liegen die optimalen Transparenz- und Widerstandswerte bei einem Wasserstoffanteil von 10 %.

## Ansprüche

1. Verfahren zum Herstellen niederohmiger, transparenter Indium-Zinnoxid-Schichten, wie sie insbesondere als transparente Elektroden auf aus amorphem, wasserstoffhaltigem Silizium bestehenden Photoleiterschichten für Bildsensorelemente verwendet werden, durch Aufdampfen oder Aufstäuben der Ausgangsmaterialien in Form von Legierungen oder Oxiden auf die Photoleiterschicht und nachträgliches Tempern in Sauerstoffatmosphäre, **dadurch gekennzeichnet**, daß die Temperung in zwei Schritten bei Temperaturen von maximal 200°C durchgeführt wird, wobei

a) im ersten Schritt zur Erreichung der Transparenz in Sauerstoffatmosphäre und

b) im zweiten Schritt für die Leitfähigkeit der Schicht in einer plasmaaktivierten Formiergasatmosphäre getempert wird.

2. Verfahren nach Anspruch 1, **dadurch gekennzeichnet**, daß die Transparenztemperung in einer Zeitdauer von mindestens 30 und maximal 60 Minuten durchgeführt wird.

3. Verfahren nach Anspruch 1 und/oder 2, **dadurch gekennzeichnet**, daß die Leitfähigkeitstemperung in einem Stickstoff-Wasserstoff-Plasma mit 10 % Wasserstoffanteil bei 20 -100 Watt Leistung, 0,5 -1,5 mbar Druck und einer Gasströmung im Bereich von 20 -100 sccm in einer Zeitdauer von 15 -30 Minuten durchgeführt wird.

FIG 1

FIG 2